# EUROPEAN PATENT APPLICATION

(11) **EP 4 432 797 A1**
(43) Date of publication of application: **18.09.2024**
(21) Application number: 23168224.6
(22) Date of filing: 17.04.2023
(51) Int. Cl.: H05K 7/20

(54) **OUTDOOR DISPLAY MODULE**

(30) Priority: 13.03.2023 CN 202310243863
(71) Applicant: Keewin Display Co., Ltd., Shanghai 200086 (CN)
(72) Inventor: ZHOU, Feng, Shanghai, 200086 (CN); LI, Wen, Shanghai, 200086 (CN)
(74) Representative: dompatent von Kreisler Selting Werner - Partnerschaft von Patent- und Rechtsanwälten mbB

(57) **Abstract**

An outdoor display module includes a housing defined therein a closed space and a recessed room formed in the closed space and a display device securely received inside the closed space. A glass panel is received in the recessed room and sealingly attached to a periphery defining the recessed room. The glass panel is securely and directly attached to a side face of the display device to reflect a large portion of radiation heat from the sun. A heat exchanger is received in the closed space and located at a rear side of the display device to dissipate heat from electronic devices and the backlight assembly inside the housing.

## Description

### BACKGROUND

### Technical Field

The present invention relates to an outdoor display module, and in particular to a display device having a unique heat reflection unit installed to allow the display device to prolong its lifespan in the outdoor environment.

### Related Art

Currently, heat dissipation device such as air-cooled device, air conditioner and heat exchange device... etc. are widely used for outdoor display devices. The principle of which is to exchange the heat generated inside the display device with cool air outside the display device in order to achieve the purpose of heat dissipation. Taking 55" double-side outdoor display device for example, when the display device stands alone outdoors, the display device receives heat from both the sun and the electronic devices inside the display device. It is found that the radiation heat from the sun and the heat generated inside the display device is about 50-50 when considering the total amount of heat the display device receives. In order to dissipate the heat and the air conditioner measure is adopted, the power required for the air conditioner is high as the heat exchange unit in the air conditioner consumes large power, which causes high manufacture cost and has only a little above five year life expectancy for this type of display device in a closed environment. When heat exchange measure is adopted, because there is no need for air compressor, the power required for the heat exchanger is only half of that for air conditioners. Due to the above fact, it is learned that the manufacture cost for heat exchanger inside the display device is 3/4 compared with the manufacture cost for air conditioners inside the display device and has a little over five year life-expectancy for this type of display device in a closed environment. Again, even the air cooled device consumes the least amount of power and has the lowest manufacture cost, this type of measure has less than two year life expectancy though. Due to short lifespan, this type of means is obsolete gradually from the market even it has the least expensive manufacture cost. As such, how to ensure the outdoor display to have enough lifespan and keep the manufacture cost as low as possible is becoming urgent each day.

### SUMMARY

The preferred embodiment hereinafter is to overcome the shortcomings existed in the current display device, using a comprehensive attachment device to solve high manufacture cost to the air cooled device or heat exchange device inside the display device.

To realize the goal, the technical perspective of the preferred embodiment involves:
a comprehensive attachment device includes a housing with a closed space and a recessed room;
a glass panel received in the recessed room and sealingly attached to a periphery defining the recessed room of the housing;
a display device installed inside the closed space and securely attached and connected to a side of the glass panel; and
a heat exchanger installed inside the housing and behind the display device.

The outdoor display module is to attach a glass panel to a side of the display device to block a portion of the radiation heat from the sun so as to reduce the heat received in the display device. After massive experiments and measurements, the radiation heat from the sun is roughly half the amount of heat received and needed to be dissipated by the display device. After the glass panel is securely and directly connected to a side of the display device, roughly 90% of radiation heat from the sun is reflected and conducted away from the display device, leaving only roughly 10% of radiation heat penetrated into the display device. Thus, when compared with conventional heat dissipation device, the preferred embodiment provided by the invention greatly reduces the heat inside the display device. A heat exchanger with much lower power may as well satisfy the need, which results in low manufacture cost and long lifespan. In addition, the attachment between the glass panel and the display device leaves no room for air, which reduces light reflection in one aspect and increases resolution in another aspect.

The display module further includes a display device which is securely attached and directly connected to the glass panel via a layer of glue.

A still other aspect of the preferred embodiment is to provide a first heat dissipation channel in the heat exchanger to communicate with the closed space.

A further aspect of the preferred embodiment of this application is to provide a communication space in the housing, which communicates with a ventilation opening also in the housing.

A further aspect of the preferred embodiment of the present invention is that the heat exchanger defines therein a second heat dissipation channel communicating with the communication space.

A further aspect of the preferred embodiment of the present invention is that a heat dissipation fan is installed on the ventilation opening.

A further aspect of the preferred embodiment of the present invention is that a second heat dissipation fan is installed in the closed space inside the housing.

Another aspect of the preferred embodiment of the present invention is that the recessed room is defined in a front side and a rear side of the housing.

Still another aspect of the preferred embodiment of the present invention is that there are two display device s respectively provided on the rear side and front side of the housing.

A further aspect of the preferred embodiment of the present invention is that the heat exchanger is provided between the two display devices.

Furthermore, the recessed room is defined in the front side of the housing.

Still, the heat exchanger is provided on the rear side of the housing.

Another aspect of the preferred embodiment of the present invention is that a backlight assembly is provided in a space behind the display device securely attached to the glass panel.

Another aspect of the preferred embodiment of the present invention is that the glass panel is an AG glass panel.

### BRIEF DESCRIPTION OF THE DRAWINGS

Fig. 1 is a front view of the outdoor display module of the preferred embodiment of the present invention;
Fig. 2 is a cross-sectional view of A-A line in Fig. 1;
Fig. 3 is cross-sectional view of B-B line in Fig. 1;
Fig. 4 is an enlargement view of A1 in Fig. 2;
Fig. 5 is an enlargement view of A2 in Fig. 2;
Fig. 6 is a right side view of the outdoor display module of the preferred embodiment of the present invention;
Fig. 7 is a cross-sectional view of C-C line in Fig. 6;
Fig. 8 is a top view of he outdoor display module of the preferred embodiment of the present invention; and
Fig. 9 shows a different embodiment of the outdoor display module of the preferred embodiment of the present invention, wherein the display module has two display device s installed therein.

### DETAILED DESCRIPTION OF THE PREFERRED EMBODIMENT

Along with the accompanying drawings, the preferred embodiment of the present invention is described.

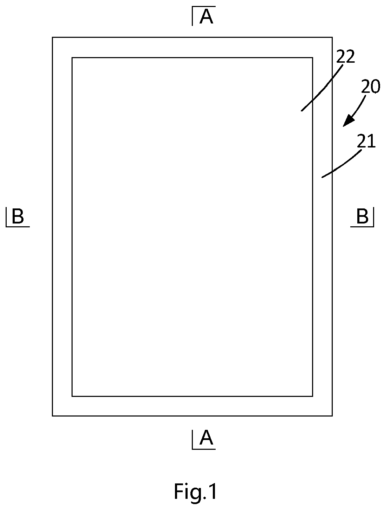

With reference to Fig. 1, the outdoor display module of the preferred embodiment of the present invention is aimed to lower energy consumption, reduce manufacture cost and maintain a reasonable lifespan. The technical feature involves attaching a glass panel to a side of the display, leaving no space existed between the glass panel and the display device such that the majority of the solar radiation heat from the sun is blocked from entering the housing of the display module and greatly reduces temperature inside the housing. Due to the fact that the temperature inside the housing of the display module is reduced, a heat exchanger ready to be installed inside the display module is only responsible for the heat from the electronic devices of the display module and the backlight assembly. The heat from the electronic devices of the display module and the backlight assembly takes only half of the total heat of the conventional outdoor display module which receives a lot of radiation heat from the sun. As the heat exchanger is only responsible for nearly half of the heat, the heat exchanger is relatively inexpensive, therefore, the total manufacture cost is lowered and lifespan of the entire display module is guaranteed.

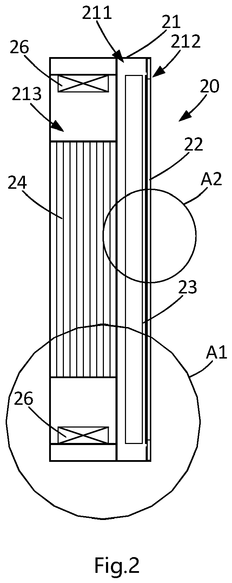

With reference to Figs. 1 and 2, the outdoor display module 20 of the preferred embodiment of the present invention includes a housing 21, a glass panel 22, a display device 23 and a heat exchanger 24. The housing 21 has a closed space 211 and a recessed room 212 formed inside the closed space 211. The glass panel 22 is mounted on top of the recessed room 212 sealingly attached to a top periphery defining the recessed room 212. The display device 23 is securely received inside the closed space 211 and securely attached to a side of the glass panel 22. The heat exchanger 24 is installed inside the housing 21 and located behind the display device 23.

After years of experiments, it is found in the conventional outdoor display module, the heat from the electronic devices and the backlight assembly take half of the total heat inside display module and the other half is from the radiation heat from the sun. The preferred embodiment places a glass panel directly on a side of the display device to effectively block a large portion of radiation heat entering the inside of the display module, which efficiently reduces almost half of heat inside the display module. In such a situation, a less expensive heat exchanger having a lower power consumption ability is fully capable of dissipate the heat inside the display module, which is environment friendly and saves up to 50% of energy when compared with conventional heat dissipation technology.

Taking 55" double-side outdoor display device for example, the radiation heat from the sun is responsible for half of the temperature rise inside the display module. Using the comprehensive attachment of the glass panel to the side of the display device, a large portion of the heat from the sun is blocked from entering the display device and this reduces almost half of the heat inside the display module. Adopting a less expensive heat exchanger is good enough to dissipate the heat and the manufacture cost of this type of heat exchanger is only half of the cost when using the conventional heat exchanger. Besides, the lifespan of this heat exchanger is guaranteed to be at least five years. The display module of the preferred embodiment of the present invention consumes the lowest power and has the longest lifespan when compared with traditional heat dissipation technique.

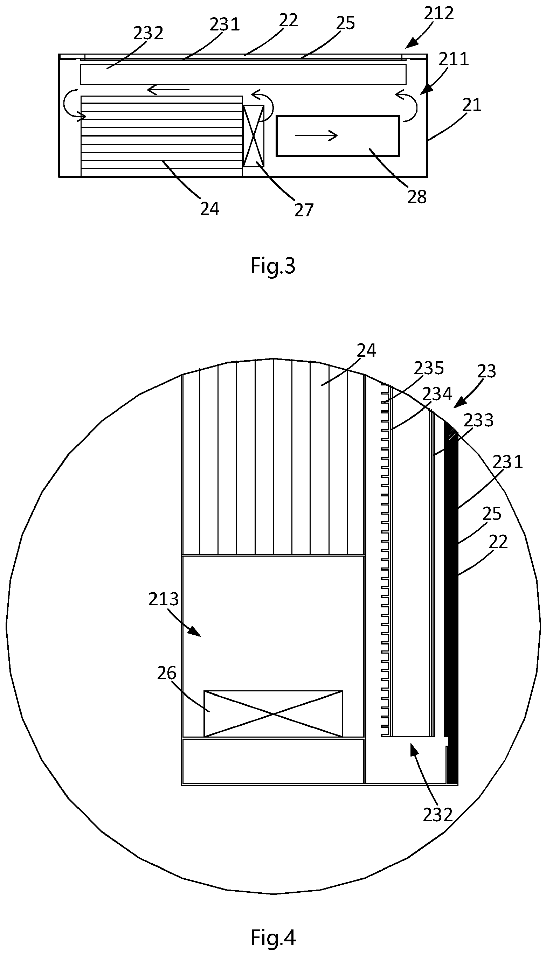

In one aspect of the preferred embodiment of the present invention, as shown in Figs. 2 and 4, the display module 23 includes a display device 231. The display device 231 is attached to the glass panel 22 through a layer of glue 25.

Specifically, the display device 231 is securely attached to the glass panel 22 via the glue layer 25.

Preferably, the size and dimension of the display device 231 is suitable for the recessed room 212 such that the display device 231 is able to completely cover the recessed room 212. The size of the glass panel 22 is slightly larger than that of the recessed room 212 so that when the glass panel 22 is attached to the side of the display device 231, an outer periphery of the glass panel 22 is sealingly connect to a periphery of the housing 21. The display device 231 is, preferably, a liquid crystal display (LCD).

Preferably, the glue layer 25 is transparent and its quality satisfies optical requirements. The glue layer 25 maybe a silicon based glue, which is stable to resist the influence from the sun.

In another aspect of the preferred embodiment of the present invention, as shown in Fig. 3, a first heat dissipation channel is formed on the heat exchanger 24 to communicate with the closed space 211.

Preferably, the first heat dissipation channel is transversely formed and there may be multiple first heat dissipation channels. With the formation of the first heat dissipation channel on the heat exchanger, the contact area of the heat exchanger with the heat is increased, which helps efficiency of dissipating the heat.

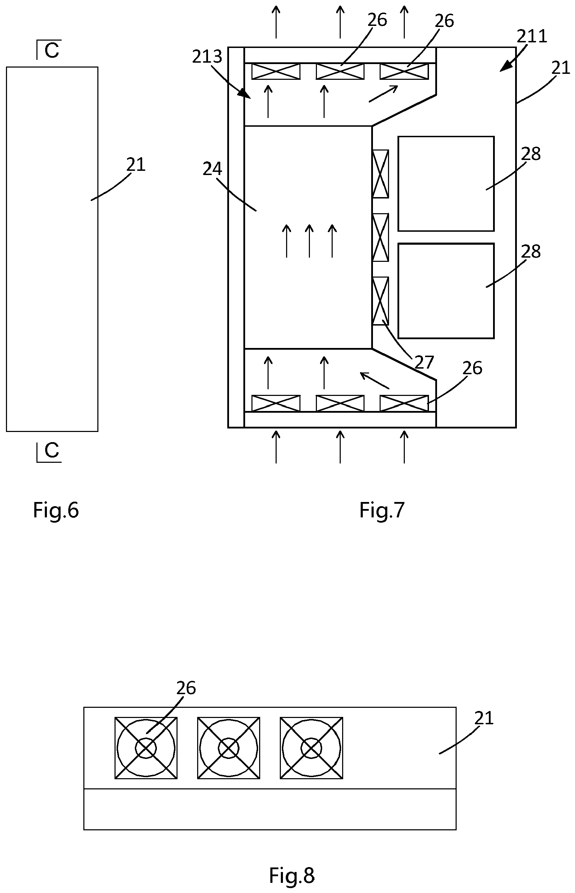

In still another aspect of the preferred embodiment of the present invention, as shown in Figs. 6 and 7, the housing 21 has a communicating space 213 and ventilation openings, which communicates with the communicating space 213. The heat exchanger 24 has a second heat dissipation channel formed thereon to communicate with the communicating space 213.

The second heat dissipation channel is able to communicate with fresh air via the communicating space 213 and the ventilation openings to fulfill the goal of dissipating heat from the heat exchanger 24.

In still another aspect of the preferred embodiment of the present invention, a second heat dissipation fan 27 is provided inside the closed space 211, as shown in Fig. 2. The second heat dissipation fan 27 forms an air circulation, as shown via arrows in Fig. 3, inside the the closed space 211. The air circulation flows through the first heat dissipation channel to pass the heat inside the closed space 211 to the heat exchanger 24. Thus, the heat inside the closed space 211 is dissipated and temperature inside the closed space 211 is balanced.

The second heat dissipation communicates with outside fresh air so that the much cooler fresh air circulates to bring out the heat dissipated by the heat exchanger 24 inside the closed space 211.

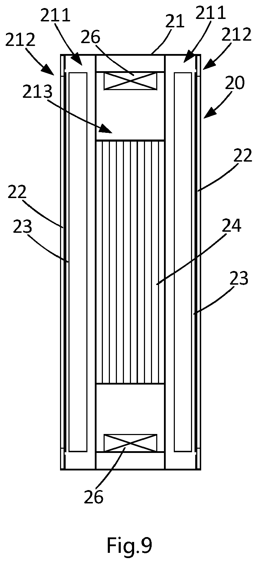

In still another preferred embodiment of the present invention, as shown in Fig. 9, it is found that the housing 21 has two corresponding recessed rooms respectively formed on a front side and rear side of the housing 21. There are two display devices 23 respectively provided to each of the two recessed rooms and the heat exchanger 24 is provided between the two display devices 23. Each of the two display devices 23 has a corresponding glass panel 22 attached thereto to reduce reflection and reduce energy consumption consequently.

Preferably, a supporting frame is provided inside the housing to support the display devices 23.

In a preferred embodiment of the present invention, as shown in Fig. 2, the recessed room 212 is formed on the front side of the housing 21 and the heat exchanger 24 is provided on the rear side of the housing 21 to suit the single display device 23.

In a different preferred embodiment of the present invention, as shown in Fig. 4, the display device 23 includes a backlight board 232 provided on a back of the display panel 231. The backlight board 232 is inside the closed space 213 and directly contacts the display panel 231, leaving a space existed there between. The backlight board 232 is fixed inside the housing 21 via the supporting frame on the side, back or bottom of the housing 21.

A space exists between the backlight board 232 and the display panel 231 to allow the air to circulate therethrough to dissipate both the backlight board 232 and the display panel 231. Further, this space provides a room for future upgrading.

In addition, the backlight board 232 includes a optical film 233 positioned in the rear of the display panel 231, a backlight light board 234 at the rear of the optical film 233 and a heat exchanger 235 at the rear of the backlight light board 234. The heat exchanger 235 is to dissipate heat from the backlight light board 234, and preferably an aluminum based heat exchanger.

The optical film 233, the backlight light board 234 and the heat exchanger 235 all together form a backlight assembly.

In the preferred embodiment of the present invention, the glass panel is an anti-glare glass, i.e., AG glass, which is a kind of glass with a coating formed on a side face thereof to increase surface roughness as well as surface area such that when light engages the surface of this glass panel, diffusion increases and reflection decreases, which increases the quality of the picture displayed on the display panel. On the other hand, under the same circumstance, when the surface roughness increases, the total surface area of the glass panel increases, which means a larger surface area is exposed to the air and thus the surface heat dissipation efficiency of the glass panel increases.

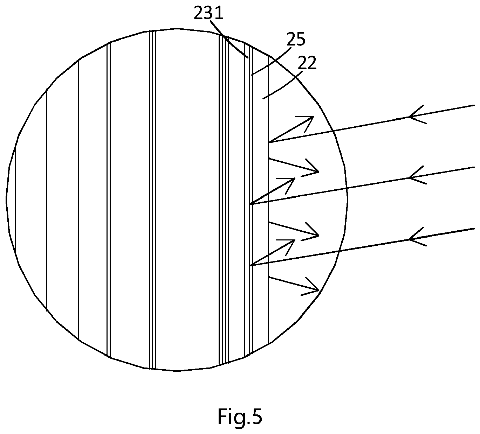

As shown in Fig. 5, the arrows indicate the paths of the sun light and the light reflection. When sun light reaches the glass panel 22, light is reflected by both the glass panel 22 and the display panel 231 such that the sun ray does not enter the housing 21, which effectively decreases temperature rise from the sun and also reduces the heat to be dissipated by the equipment.

As shown in Figs. 3 and 7, electronic devices 28 are provided inside the closed space 211 to electrically connect to the display device 23 to provide electricity to and control of the display device 23.

Different embodiments of the present invention are aimed at providing a resolution to the radiation heat from the sun. The glass panel securely attached to the side of the display device is able to solve the problem satisfactorily. In addition, the heat exchanger at the back of the backlight assembly is able to transmit the heat from the backlight assembly to the closed space and eventually dissipate the heat with the help of air circulation. The heat exchanger is able to effectively resolve the heat problem caused by the backlight assembly and electronic devices. The integration of different kinds of elements into the preferred embodiment of the present invention reduces the overall energy consumption, which is fully in compliance with international environment requirements.

## Claims

1. An outdoor display module comprising:
a housing defined therein a closed space and a recessed room formed in the closed space;
a display device securely received inside the closed space;
a glass panel received in the recessed room and sealingly attached to a periphery defining the recessed room, wherein the glass panel is securely and directly attached to a side face of the display device; and
a heat exchanger received in the closed space and located at a rear side of the display device.

2. The outdoor display module as claimed in claim 1, wherein the display device includes a display panel securely attached to a side of the glass panel via a glue layer.

3. The outdoor display module as claimed in claim 1, wherein the heat exchanger has a first heat dissipation channel in communication with the closed space.

4. The outdoor display module as claimed in claim 1, wherein the housing further has a communication space and a ventilation opening in communication with the communication space.

5. The outdoor display module as claimed in claim 4, wherein a first heat dissipation fan in mounted on the ventilation opening.

6. The outdoor display module as claimed in claim 1, wherein a second heat dissipation fan is provided inside the closed space.

7. The outdoor display module as claimed in claim 1, wherein the recessed room is defined in a front side and a rear side of the housing, the display device includes two display panels respectively received in the front recessed room and the rear recessed room of the housing; and the heat exchanger is mounted between the two display panels.

8. The outdoor display module as claimed in claim 1, wherein the recessed room is defined in a front side of the housing and the heat exchanger is provided at a rear side of the housing.

9. The outdoor display module as claimed in claim 1 further comprising a backlight assembly located at a rear side of the display device leaving a space defined between the backlight assembly and the display device.

10. The outdoor display module as claimed in claim 1, wherein the glass panel is an AG glass.
